# EUROPEAN PATENT APPLICATION

(11) **EP 4 766 106 A1**
(43) Date of publication of application: **24.06.2026**
(21) Application number: 25225548.4
(22) Date of filing: 19.12.2025
(51) Int. Cl.: H10H 20/831, H10H 20/858

(54) **LED WITH TUNED LUMINANCE PROFILE**

(30) Priority: 20.12.2024 US 202418990792
(71) Applicant: Lumileds Singapore Pte. Ltd., Singapore 768925 (SG)
(72) Inventor: DiMaria, Jeff, San Jose, 95131 (US); Shen, Yu-Chen, San Jose, 95131 (US); Gordon, Luke, San Jose, 95131 (US)
(74) Representative: dompatent

(57) **Abstract**

An LED may be tuned by thermal effects through the contacts attached to the semiconductor regions. The contacts may have gaps or voids between or within them to create nonuniformity in the thermal distribution of the semiconductor regions, which will in turn increase or decrease luminance output at those spots. The contacts may be actively heated or cooled to further affect the temperature of the semiconductor regions nearest the contacts. The layout of the contacts may be chosen to produce a fully addressable LED with precise luminance tuning.

## Description

### FIELD OF THE INVENTION

The invention relates generally to optical elements, specifically LEDs with tuned luminance profiles.

### BACKGROUND

Semiconductor light emitting diodes and laser diodes (collectively referred to herein as "LEDs") are among the most efficient light sources currently available. The emission spectrum of an LED typically exhibits a single narrow peak at a wavelength determined by the structure of the device and by the composition of the semiconductor materials from which it is constructed. By suitable choice of device structure and material system, LEDs may be designed to operate at ultraviolet, visible, or infrared wavelengths. LEDs may be combined with one or more wavelength converting materials (generally referred to herein as "phosphors") that absorb light emitted by the LED and in response emit light of a longer wavelength.

Luminance of an LED is an important parameter for many lighting applications including automotive forward lighting, projectors, camera flash, and any application where shaping of the far-field radiation pattern is employed. Several methods of increasing or tuning the luminance of LED and phosphor converted LED systems have been proposed and successfully employed, namely using electrical modulation schemes. These schemes include judicious contact placement or layer thickness/material variation to tune device lateral resistance and active modulation through segmented driving schemes to achieve the desired luminance distribution.

### SUMMARY

The proposed novel method and devices may employ an intentional thermal profile across the LED emitting area to modulate local junction current density and subsequent local light emission. Modulating light emission by thermal distribution is another degree of freedom in the LED device design - it can lead to higher luminance for a given contact layout, or lower density of eVias and nVias required to achieve the same device luminance. Active tuning can also be achieved via thermal means, separately from electrically driving the LED directly. eVias (p-side electrical vias through the p-mirror layer) and nVias (n-side electrical vias, i.e. embedded n-contacts in the CSP architecture) cause either reduce optical efficiency due to metal/passivation dielectric losses (eVias, nVias), or loss of active area (nVias) due to etch through active area to create the embedded contact.

In other words, embodiments of this invention may use thermally insulating materials or gaps between electrically and thermally conductive contacts in order to enhance the luminance distribution in the die center, at the die edge, other areas, or to achieve a flat luminance profile.

Devices and methods of the invention may be used in applications such as automotive forward lighting, projectors, camera/phone flash, flashlights, street lighting, stadium lighting, general lighting, and any beamed application requiring shaped far-field illuminance.

These and other embodiments, features and advantages of the present invention will become more apparent to those skilled in the art when taken with reference to the following more detailed description of the invention in conjunction with the accompanying drawings that are first briefly described.

### BRIEF DESCRIPTION OF THE DRAWINGS

Figure 1 schematically illustrates a cross-sectional view of light emitting structure with contacts spaced out from each other to create thermal spot of increase luminance in the semiconductor region.
Figure 2 schematically illustrates a cross-sectional view of light emitting structure with an integral contact that has a void to create a thermal spot of increased luminance in the semiconductor region.
Figure 3 schematically illustrates a cross-sectional view of light emitting structure with an integral contact that has a void to create a thermal spot of increased luminance in the semiconductor region.
Figure 4 schematically illustrates a cross-sectional view of light emitting structure with a contact pulled away from the edges to create thermal spot of increased luminance in the semiconductor region.
Figure 5 schematically illustrates a cross-sectional view of light emitting structure with contacts thermally connected with thermoelectric controllers to create thermal spots of increased luminance in the semiconductor region.
Figure 6 schematically illustrates a cross-sectional view of light emitting structure with contacts thermally connected with thermoelectric controllers to create thermal spots of increased luminance in the semiconductor region.
Figure 7 illustrates a plan view of the contacts shown in Fig. 6 as well their connections closer to the edges of the substrate than they are.

### DETAILED DESCRIPTION

The following detailed description should be read with reference to the drawings, in which identical reference numbers refer to like elements throughout the different figures. The drawings, which are not necessarily to scale, depict selective embodiments and are not intended to limit the scope of the invention. The detailed description illustrates by way of example, not by way of limitation, the principles of the invention.

In many LEDs, the metallic under bump metallization (UBM) and bonding layers (BL) provide an electrical path for the carriers, and also spread heat below the die. The bonding layer spreads heat laterally, and the UBM spreads heat both laterally, vertically, and out of the die into the substrate.

For UBMs and bonding layers, reducing their lateral extent or patterning them allows modulation of their heat spreading capabilities. This may increase the local thermal resistance at a given region of the semiconductor active region. The energy distribution of the local semiconductor carriers and bandgap of the semiconductor materials can be modulated by increased local heating. Hotter regions of the LED may have more energetic carriers and lower bandgap, resulting in lower local bias voltage required for a given current flow. Alternatively or additionally, these hot regions have a lower electrical resistance, and for the same applied voltage at the device level, these regions will experience higher local current flow and greater light emission. Conversely, cooler regions have higher apparent local resistance and will have less current flow/light emission through the active region.

The bonding layer that carries current from the UBM to the n-side and p-side device contacts can be patterned in a way that does not increase electrical resistance, but increases local thermal resistance of a given point on the junction. This leads to heating in regions where the junction thermal resistance is higher. The UBM can be patterned the same or similarly, and in addition the effect of patterning the UBM is much greater in practice because it is also the only way for heat to exit the die. Die regions not in thermal contact with or close thermal contact with UBM have significantly higher thermal resistance and higher temperature than regions in thermal contact with UBM. In thin-film flip-chip devices (where the substrate is removed), the chip is supported by gold bumps contacting the substrate - these serve the same electrical and thermal purpose as the UBM (in chip scale package - CSP - this is evaporated or plated metal).

In a conventional device with uniform luminance, the BL/UBM may have no gaps and may be in full physical and/or thermal contact with the die layers above, providing a uniform thermal resistance across the active region. There the BL/UBM may have a single polarity. Uniform or nearly uniform thermal resistance could also be obtained when there are gaps in the BL/UBM as small as technologically feasible (e.g. ~1 micron or so) where the BL/UBM may include both polarities.

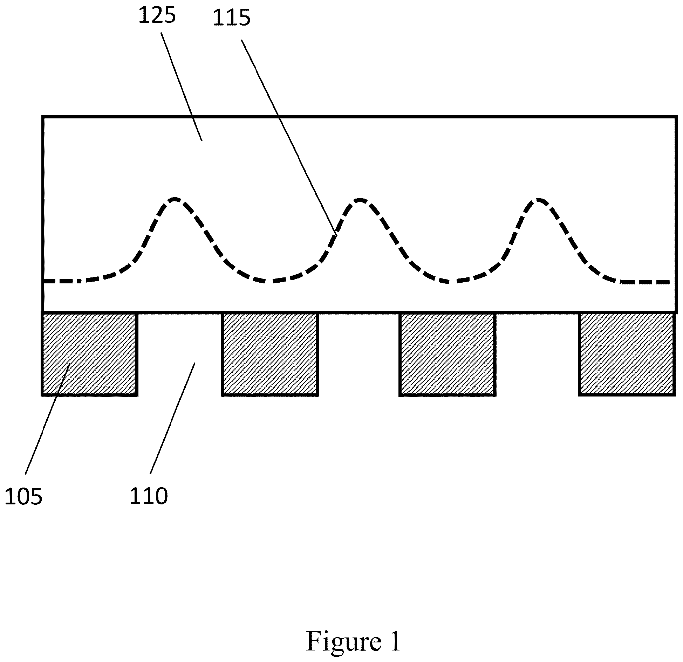

According to embodiments of the invention, Figure 1 describes a light emitting device where there is a significant air gap or insulator between contacts 105 of different polarities and/or the same polarity. Figure 1 shows multiple contacts 105 and gaps 110 between them. The contacts 105 may each be in direct physical contact and/or thermal contact with the semiconductor region 125, particularly the part of the semiconductor region 125 which they overlap in the vertical direction. The contacts 105 may be in direct contact with the semiconductor region 125 at a first surface, and at a second surface opposing the first surface may be in direct and/or thermal contact with a substrate (shown in other figures). In this way the contacts 105 may conduct heat from the semiconductor region 125 to the substrate. The contacts 105 may each be driven by a driver included on or in the substrate upon which the light emitting device is disposed. That is, the contacts 105 may each be electrically connected via the substrate to a driver. The contacts 105 may be at least one of a UBM and BL, such as both. Alternatively, the contacts 105 may only include the UBM with the BL still in between the contacts 105 and the semiconductor region 125, for example, where the BL doesn't include gaps 110 and also covers a majority of a surface of the semiconductor region 125, such as all the surface. If the contact 105 includes both, then the UBM may be below the BL such that the UBM is in direct contact with the solder and/or the substrate, or at least closer to the substrate than the BL. The BL may not be in direct contact with the substrate or the solder, and may be in direct contact with the semiconductor region 125, such as at the n-type or p-type region (alternatively, there may be a mirror layer between the BL and the semiconductor region 125). That is, the BL may be electrically connected with the semiconductor region 125, or parts of it. The BL may be a current spreading layer that covers most of the semiconductor region 125, and may be about a several microns in thickness, such as around 1 micron. The BL and or UBM may be different or same materials as each other, and may each comprise one or more of Ti, Ni, Cu, Au, Ag, and Al. The contacts 105 may be different polarities as each other or the same polarity. Whether the contacts 105 are different polarities, they may each be spaced apart from and disconnected from each other.

The active region may included in the semiconductor region 125 and arranged to emit output light of a first wavelength in proportion to the line 115. The active region may be between an n-type region and p-type region, either of which may face the contacts 105 according to the desired structure.

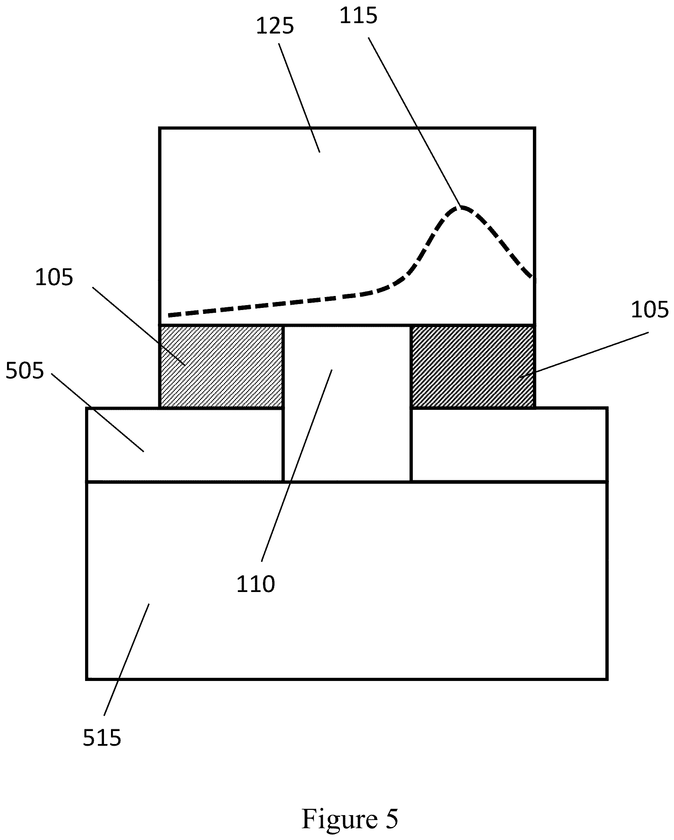

The gaps 110 can have different lateral profiles depending on the desired luminance profile. Figure 1 illustrates with an imaginary, dotted line 115 representing one or more (e.g., all) of the temperature, current density, and light output distribution of the active region relative to the other parts of the active region. That is, for the conditions under consideration, the temperature, current density, and light output are proportional to each other. The line 115 rises towards and peaks above the middle of the gap 110, illustrating the increase in temperature in the parts of the active region over the gaps 110 and the corresponding increase in current density and light output. The line 115 with respect to a middle of the light emitting device, although it need not be. For example, Fig. 1 shows that line 115 over a gap 110 may be symmetric about a middle of the gap 110, although it need not be. The line 115 may also be flat or roughly flat over some of the area overlapping the contacts 105, such as at the edges of Fig. 1. Fig. 1 shows three maximum peaks of line 115 over the middle of the gap 110, so that the luminance of the active region is greatest when overlapping the middle of the gaps 110, and lowest at places overlapping the contacts 105. "Overlapping" as used in this specification may refer to where an imaginary vertical straight line drawn from a first element intersects a second element above or below it, where verticality is perpendicular to a plane of the substrate's surface facing the semiconductor region 125 (such as shown in Fig. 5). "Entirely overlapped" by the second element may mean if a vertical line is drawn at any point in the first element in the direction of the second element, it intersects the second element. In this case the second element may not be entirely overlapped by the first element if the second element is greater in size than the first element.

Gap 110 may include only air in the final lighting device or may include a solid dielectric layer partially or entirely filling gap 110, so that it may directly contact one or multiple contacts 105 forming the gap 110. The dielectric material may be one or more of AlOx, TiOx, CeOx, CaOx, ZnOx, TaOx, SiO₂ and SiN, or other low thermal conductivity oxides or nitrides (x may be a number, such an integer, such as 2, for example).

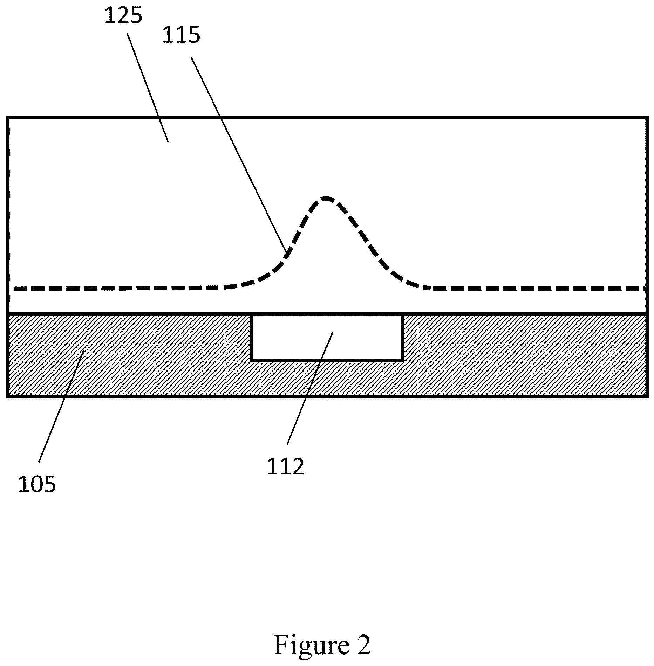

According to embodiments of the invention, Figure 2 illustrates a device where the contact 105 is thinner in one region with a cavity 112 with higher thermal resistance than the metal of the contact 105 while having the same electrical polarity throughout. The cavity 112 may include or be entirely filled with air or a solid dielectric structure. The dielectric material may be one or more of AlOx, TiOx, CeOx, CaOx, ZnOx, TaOx, SiO₂ and SiN, or other low thermal conductivity oxides or nitrides (x may be a number, such an integer, such as 2, for example).

The thickness of the contact 105 at the cavity 112 determines the lateral thermal conductivity and the thickness of the cavity 112 determines the vertical thermal resistance of the local die junction above the cavity 112. The cavity 112 may be formed by a surface of the contact 105 opposite a surface of the semiconductor region 125 and side walls extending between the two aforementioned surfaces which may be perpendicular with one or both surfaces. The thickness of the contact 105 at the cavity 112 may be from 10-70% of the thickness of the contact 105 outside the cavity 112, such as from 20-60%, such as from 30-50%. The thickness of the cavity 112 may of course correspond to the "missing" thickness/thickness percentage of the contact 105. The contact 105 may be monolithic and an integral structure, and may be of a single polarity.

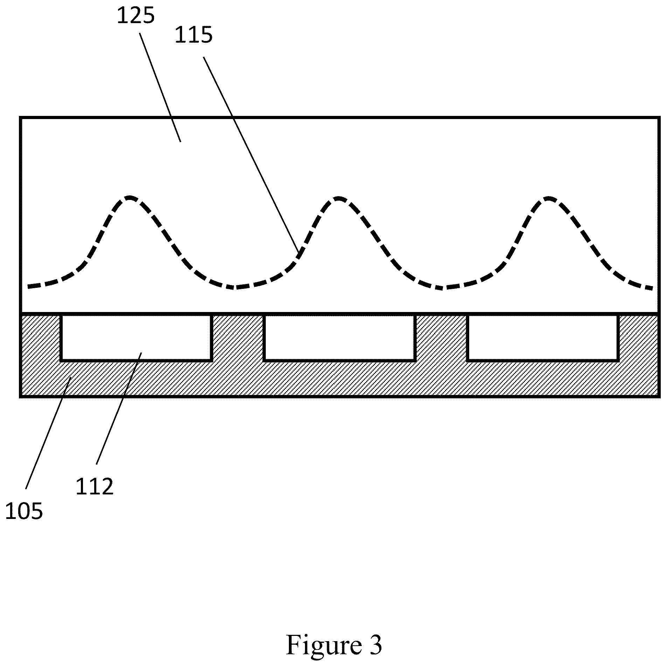

According to embodiments of the invention, Fig. 3 illustrates a device where the contact 105 has multiple cavities 112 within it having the same or similar characteristics as that shown in Fig. 2. The contact 105 may be monolithic and an integral structure, and may be of a single polarity. For example, the contact 105 may form a grid of cavities 112 facing the semiconductor region 125.

The contacts 105 may be patterned to have gaps 110 and/or cavities 112 in any way according to the luminance profiles desired. Contacts 105 that are spaced with gaps 110 between them may themselves have cavities 112 as well. Luminance profiles may include where, in a plan view, the peak luminance is at the center of the active region, at all edges of the active region circumscribing the device, or forming arbitrary patterns within the active region, such as peak luminance regions spaced apart from each other to form a regular grid.

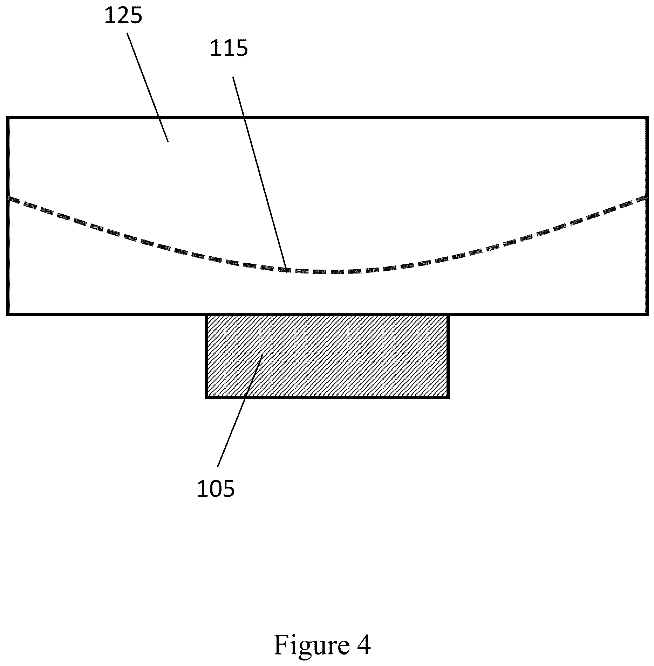

According to embodiments of the invention, Figure 4 illustrates a device where the contact 105 is pulled away from the edge of the die to achieve a light emission profile that is greater at the edges than at the center. The line 115 shows the temperature, current density, and light output to be higher at the edges compared to the middle of the active region in the semiconductor region 125. The lowest part of the line 115 is at the middle of the contact 105 and the semiconductor region 125. The contact 105 may be spaced apart from the edges at a distance of from 30 to 300 microns.

In Figs. 2-4, if the semiconductor region 125 has a single integral contact 105 on one side of one polarity, then the semiconductor region 125 may have another contact on another side (e.g., an opposite side) of a different polarity (not shown), e.g., as a vertical thin film LED.

According to embodiments of the invention, active heating or cooling may be used to adjust the luminance profile of a lighting device as desired. Figure 5 illustrates a lighting device with a thermoelectric cooler or heater (i.e. thermoelectric controller) where the thermal distribution can be actively tuned by heating or cooling the contacts 105. In the figure the right side contact 105 is being heated and/or the left side contact 105 is being cooled, although the heating/cooling capabilities of each contact 105 may be the same even if they are applied differently as desired. As a result of the heating on the right side contact 105 and/or cooling on the left contact 105, the right side of the semiconductor region 125 overlapping with the right contact 105 has greater luminance. The thermoelectric controller (TEC) 505 may be in direct contact with individual contacts 105, and may be in direct contact with the substrate 515 that may serve as a heat sink. The substrate 515 may be made of any suitable material, such a material with high thermal conductivity of 200 W/mK or greater, such as of 300 W/mK or greater, such as from 200-400 W/mK. An example material is a material comprising aluminum, such as AlN.

Alternatively, a contact 105 stripe down the center of the semiconductor region (same as that shown in Fig. 4) can be actively heated with a thermoelectric heater in direct contact to dynamically increase the luminance coming from the center of the semiconductor region 125.

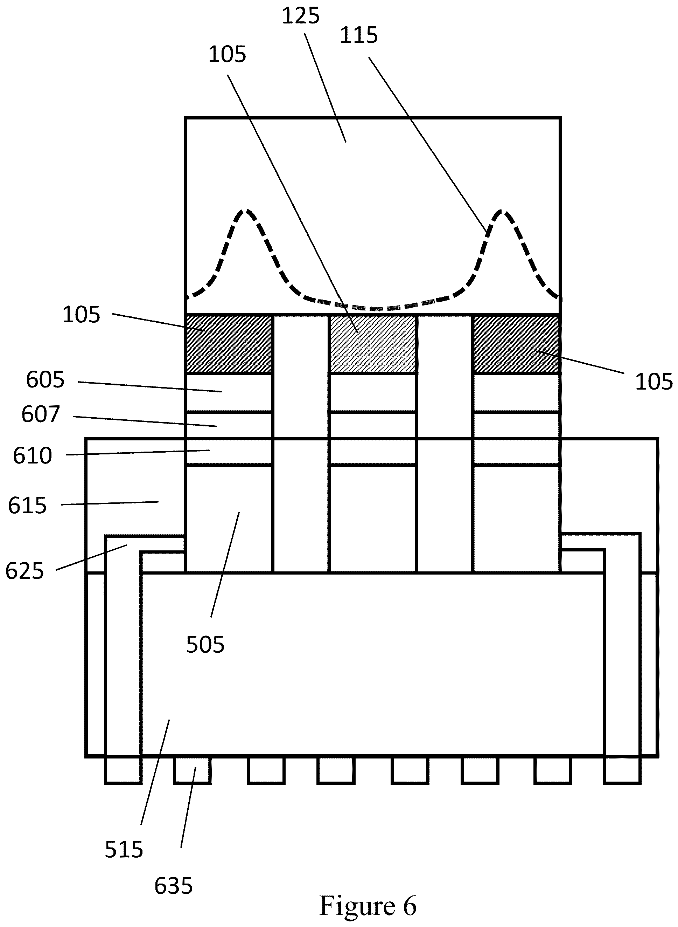

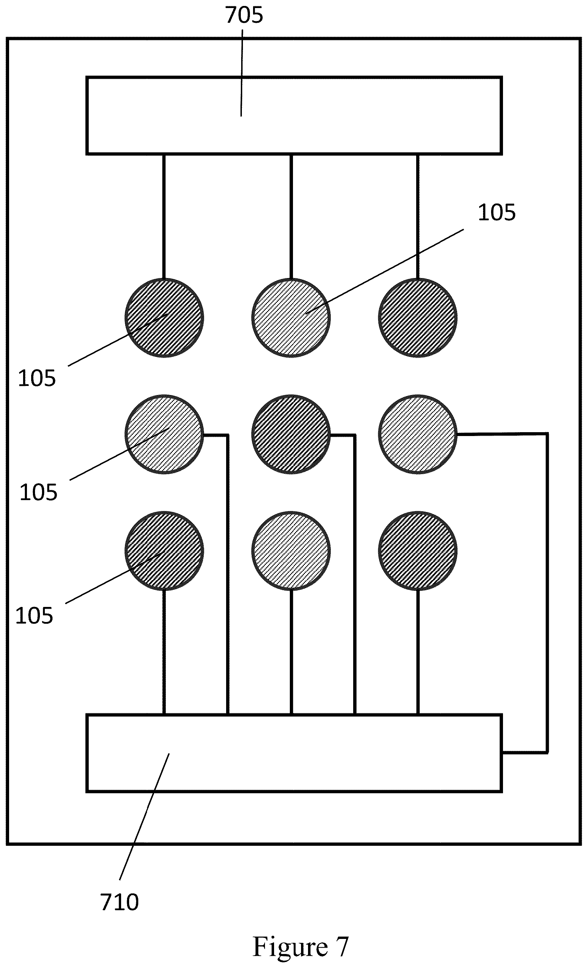

This idea of active heating/cooling can be extended to a fully addressable emitter to achieve arbitrary luminance profiles via active thermal modulation as illustrated in Figures 6 and 7. Here the contacts 105 are segmented to leave small gaps between contacts 105 arrayed across the die. The contacts 105 may be in direct contact with a solder 605, which may include tin. Below the solder 605 is an electrically insulating layer 610 with low electrical conductivity and relatively low thermal resistance (e.g., 10-40 W/mK, e.g., SiNx) to electrically isolate the TEC 505 and metallization 607 from each other. The contacts 105 of the same polarity may be electrically connected far from the semiconductor region 125 and may be thermally isolated from the substrate 515 to prevent thermal crosstalk. Insulator 615 may serve this purpose, and may be made of a material such as SiO₂, and may have thermal conductivity of 1 W/mK or lower, such as 0.5 W/mK or lower. Alternatively, or in conjunction, the metallization 607 can also be made with a material with moderate electrical conductivity and relatively high thermal resistance (e.g. Inconel, Constantan metal alloys) in order to provide thermal isolation between contacts 105 of the same electrical polarity. The LED electrodes fanout can also be arranged vertically as vias through the substrate 515, offset from the TEC 505. The LED electrode vias (which could also route through the substrate 515) would then preferably have thermal insulation from the substrate 515 since the substrate 515 also serves as the heatsink. The fanout of TEC electrodes 625 can either be in-plane or as vias through the substrate 515 as shown in Fig. 6, with addressable electrodes 635 at the bottom of the substrate 515 driven independently. A plan view taken at of the contacts 105 is shown in Fig. 7, where the contacts 105 are connected with each other at a positive connection 705 or a negative connection 710 spaced apart from the contacts 105.

This disclosure is illustrative and not limiting. Further modifications will be apparent to one skilled in the art in light of this disclosure and are intended to fall within the scope of the appended claims.

Further aspects of the invention:
1. A light emitting device, comprising:
   a semiconductor structure comprising an active region arranged to emit light of a first wavelength, the active region comprising a first region and a second region; and
      at least one metal contact disposed on the semiconductor structure and overlapping the first region;
   wherein the first region of the active region is configured to have a lower temperature in operation of the light emitting device than the second region.
2. The light emitting device of aspect 1, wherein the first region is configured to have lower current flow in operation of the light emitting device than the second region.
3. The light emitting device of aspect 2, wherein the first region is configured to have a lower luminance in operation of the light emitting device than the second region.
4. The light emitting device of aspect 1, wherein the at least one metal contact comprises two or more metal contacts with a gap in between, the second region overlaps the gap.
5. The light emitting device of aspect 4, wherein the gap is filled with a dielectric material.
6. The light emitting device of aspect 4, wherein at least some of the two or more metal contacts are arranged with different polarities.
7. The light emitting device of aspect 1, wherein the second region does not overlap any of the at least one metal contacts.
8. The light emitting device of aspect 1, further comprising a solder in direct contact with the at least one metal contact.
9. The light emitting device of aspect 1, wherein each of the at least metal contact comprises a bonding structure in direct contact with the semiconductor structure and an under bump metallization in direct contact with the bonding structure.
10. The light emitting device of aspect 9, wherein the bonding structure comprises a different metal than the UBM.
11. A light emitting device, comprising:
   a semiconductor structure comprising an active region arranged to emit light of a first wavelength; and
   a metal contact disposed on the semiconductor structure, comprising a first metal region and a second metal region outside the first metal region, a thickness of the first metal region being thinner than a thickness of the second metal region;
   wherein a first region of the active region overlapping the first metal region has a higher heat than a second region overlapping the second metal region.
12. The light emitting device of aspect 11, wherein the metal contact forms a cavity overlapping the first metal region.
13. The light emitting device of aspect 12, wherein the cavity is filled with air.
14. The light emitting device of aspect 12, wherein the cavity is filled with a solid dielectric material.
15. The light emitting device of aspect 11, wherein the metal contact comprises a plurality of thinner metal regions comprising the first metal region, and the plurality of thinner metal regions each has a thickness thinner than the second metal region.
16. The light emitting device of aspect 15, wherein the metal contact forms a plurality of cavities.
17. A light emitting device, comprising:
   a semiconductor structure comprising an active region arranged to emit light of a first wavelength;
   a plurality of metal contacts disposed on the semiconductor structure; and
   a plurality of thermoelectric heaters or coolers each in direct contact with one of the metal contacts, the thermoelectric heaters or coolers each spaced apart from each other and being individually addressable.
18. A light emitting device of aspect 17, wherein the thermoelectric heaters or coolers are arranged to heat or cool the metal contacts so that an emission of the active region has a nonuniform luminance profile .
19. A light emitting device of aspect 17, wherein the metal contacts are spaced out from each other to form a grid.
20. A light emitting device of aspect 17, wherein at least some of the metal contacts have different polarities from each other.

## Claims

1. A light emitting device, comprising:
a semiconductor structure comprising an active region arranged to emit light of a first wavelength; and
a metal contact disposed on the semiconductor structure, comprising a first metal region and a second metal region outside the first metal region, a thickness of the first metal region being thinner than a thickness of the second metal region;
wherein a first region of the active region overlapping the first metal region has a higher heat than a second region overlapping the second metal region.

2. The light emitting device of claim 1, wherein the metal contact forms a cavity overlapping the first metal region.

3. The light emitting device of claim 2, wherein the cavity is filled with air.

4. The light emitting device of claim 2, wherein the cavity is filled with a solid dielectric material.

5. The light emitting device of claim 4, wherein the dielectric material is one of an oxide or nitride.

6. The light emitting device of claim 1, wherein the metal contact comprises a plurality of thinner metal regions comprising the first metal region, and the plurality of thinner metal regions each has a thickness thinner than the second metal region.

7. The light emitting device of claim 6, wherein the metal contact forms a plurality of cavities.

8. The light emitting device of claim 1, further comprising:
a plurality of metal contacts disposed on the semiconductor structure and comprising the metal contact; and
a plurality of thermoelectric heaters or coolers each in direct contact with one of the metal contacts, the thermoelectric heaters or coolers each spaced apart from each other and being individually addressable.

9. The light emitting device of claim 1, wherein the first region is arranged to have higher luminance than the second region.

10. The light emitting device of claim 1, wherein the first region is arranged to have higher current density than the second region.

11. The light emitting device of claim 1, further comprising a solder in direct contact with the metal contact.

12. The light emitting device of claim 1, wherein the metal contact comprises a third metal region having a same thickness as the first metal region, the second metal region being between the first metal region and the third metal region.

13. The light emitting device of claim 1, wherein the metal contact comprises one or more of Ti, Ni, Cu, Au, Ag, and Al.

14. The light emitting device of claim 1, wherein the thickness of the first metal region is 10-70% of the thickness of the second metal region.

15. The light emitting device of claim 1, wherein the first metal region and the second metal region have a same polarity.
